# Europäisches Patentamt

## European Patent Office

## Office européen des brevets

(11) Numéro de publication: **0 090 704**
**B1**

# FASCICULE DE BREVET EUROPÉEN

(45) Date de publication du fascicule du brevet:
10.06.87

(51) Int. Cl.⁴: **H 01 L 27/02**, H 01 L 23/52

(21) Numéro de dépôt: **83400537.3**

(22) Date de dépôt: **15.03.83**

(54) Circuit intégré prédiffusé, et procédé d'interconnexion des cellules de ce circuit.

(30) Priorité: **26.03.82 FR 8205245**

(43) Date de publication de la demande:
**05.10.83 Bulletin 83/40**

(45) Mention de la délivrance du brevet:
**10.06.87 Bulletin 87/24**

(84) Etats contractants désignés:
**BE DE GB IT NL SE**

(56) Documents cité:
**EP-A-0 001 209**

**IEEE CIRCUITS AND SYSTEMS MAGAZINE, vol. 3, no. 3, septembre 1981, pages 14-18, New York, USA, R. NOTO et al.: "Automated universal array" JAPANESE JOURNAL OF APPLIED PHYSICS, vol. 19, suppl. 19-1, 1980, pages 203-206, Tokyo, JP. M. ASHIDA et al.: "A 3000-gate CMOS masterslice LSI"**

(73) Titulaire: **THOMSON- CSF TELEPHONE, 146, Boulevard de Valmy, F-92707 Colombes (FR)**

(72) Inventeur: **Charransol, Pierre, THOMSON- CSF SCPI 173, Bld. Haussmann, F-75379 Paris Cedex 08 (FR)**
Inventeur: **Audrix, Jean- Claude, THOMSON- CSF SCPI 173, Bld. Haussmann, F-75379 Paris Cedex 08 (FR)**
Inventeur: **Athenes, Claude, THOMSON- CSF SCPI 173, Bld. Haussmann, F-75379 Paris Cedex 08 (FR)**

(74) Mandataire: **Weinmiller, Jürgen, Lennéstrasse 9 Postfach 24, D-8133 Feldafing (DE)**

## Description

La présente invention se rapporte aux circuits intégrés prédiffusés dans lesquels on confectionne à l'avance un réseau de cellules identiques qui sont ensuite interconnectées à la demande entre elles pour réaliser les fonctions logiques désirées. Elles concernent également les procédés qui permettent cette interconnexion des cellules.

La technique initiale de réalisation des circuits intégrés consiste à partir d'un circuit logique désiré et à transposer les fonctions logiques de ce circuit en un ensemble de transistors interconnectés, ce qui réalise une cellule élémentaire. On interconnecte ensuite ces cellules entre elles pour réaliser la fonction logique du circuit désiré.

Ce procédé, qui a été mis au point pour des portes élémentaires, s'est révélé inexploitable à partir d'un certain degré de complexité de la fonction logique à intégrer. En effet les circuits intégrés à large intégration actuelle comportent plusieurs dizaines de milliers de transistors, et on conçoit aisément que l'implantation un par un de ces transistors, et des connexions correspondantes entre tous ceux-ci, prennent un temps qui est parfaitement prohibitif.

On s'est donc dirigé vers des systèmes de conception assistée par ordinateur, dans lesquels on utilise des cellules standardisées archivées dans une bibliothèque. L'interconnexion entre ces cellules peut elle-même être réalisée, tout au moins de manière assistée, à l'aide d'algorithmes de câblage exploités par un ordinateur.

Il existe à l'heure actuelle deux techniques fondées sur ce principe et dont les avantages et les inconvénients sont complémentaires.

La technique dite des cellules standard consiste à utiliser une bibliothèque de fonctions logiques relativement complexes que l'on place sur la surface disponible d'un substrat en tenant compte des interconnexions qui sont nécessaires entre elles. L'emplacement des cellules tient compte de l'interconnexion et vice versa. On peut ainsi utiliser au maximum la surface de substrat disponible pour l'intégration en plaçant les cellules et les interconnexions de manière à serrer le tout au maximum. Par contre chaque circuit intégré est complètement spécifique, ce qui impose d'avoir un jeu de masques complet spécifique de ce circuit pour le réaliser. Toute modification qui se révèle nécessaire au cours du développement du circuit peut ainsi réagir sur la totalité des masques, qui sont alors à refaire dans leur ensemble. De même pour obtenir un circuit modifié, il faut reprendre, après avoir modifié le masques, la totalité du processus de fabrication, qui est relativement long. Le gain en surface de substrat se paye ainsi par une perte de temps de réalisation.

L'autre technique, dite des réseaux prédiffusés, consiste à réaliser des ensembles de cellules très simples, identiques entre elles, et alignées selon une série de rangées séparées par des espaces libres d'une largeur déterminée.

La réalisation de la fonction logique à intégrer se fait lors d'une dernière étape du procédé de fabrication par la déposition d'un réseau de connexions en aluminium au travers d'un masque spécifique de la fonction logique désirée. Ce réseau d'interconnexions doit bien entendu respecter les limites topologiques fixées par la disposition des rangées de cellules prédiffusées. Comme la place réservée pour les interconnexions est nécessairement limitée, on aboutit, dès que l'on a une fonction un peu complexe à intégrer, à une saturation des passages réservés aux connexions. A ce moment là il reste des cellules non utilisées qui ne peuvent pas être connectées, et l'on aboutit ainsi à une perte de surface utile du substrat. A l'inverse on gagne en rapidité d'exécution puisque l'on n'a plus besoin de réaliser que deux ou trois masques spécifiques, et que la fabrication du circuit nécessite seulement la déposition d'une grille d'interconnexion en aluminium sur un substrat comportant toutes les cellules, ce qui est l'étape la plus facile et la plus rapide du procédé de fabrication. Les étapes longues et difficiles ont été faites par avance lors de la fabrication en série des réseaux prédiffusés dont on peut disposer en stock.

On connait par le document EP-A-0 001 209 un circuit intégré dans lequel des cellules de base sont prédiffusées dans une pastille semiconductrice suivant une disposition en lignes et en colonnes, on y prévoit le passage de connexions au niveau de cellules inutilisées dont l'oxyde isolant est recouvert par les connexions obtenues par métallisation.

Pour concilier les avantages de ces procédés, et en éviter les inconvénients, l'invention propose un circuit intégré prédiffusé du type comportant sur un substrat des rangées de cellules de base, dont certaines inactives permettent le passage de connexions, caractérisé en ce qu'il comprend une succession continue de rangées alternativement de type N et P dans lesquelles chaque cellule de base comporte deux transistors MOS qui sont mis en série par une électrode drain source commune et qui ont leurs grilles distinctes, les points de connexion des électrodes étant situés dans l'alignement des points de connexion des grilles, ce qui permet le passage d'au moins trois lignes de connexion longitudinales entre deux alignements de points de connexion desservant les mêmes cellules de base.

D'autres particularités et avantages de l'invention apparaitront clairement dans la description suivante présentée à titre d'exemple non limitatif et faite en regard des figures annexées qui représentent:
- la figure 1, le dessin d'une cellule de base connue;
- la figure 2, le schéma de l'implantation d'un circuit prédiffusé connu;
- la figure 3, le dessin de la cellule de la figure 1 connectée pour réaliser une porte logique;

- la figure 4, le dessin de six cellules de base mitoyennes selon l'invention;
- la figure 5, le schéma d'une porte NAND;
- la figure 6, le dessin de deux cellules de base prédiffusées selon l'invention pour réaliser la porte de la figure 5;
- la figure 7, le dessin des connexions pour réaliser la porte de la figure 5 avec les cellules de la figure 6;
- la figure 8, le dessin complet de la réalisation selon l'invention de la porte de la figure 5;
- la figure 9, le schéma d'une bascule D;
- la figure 10, le schéma d'une porte NOR utilisée dans le schéma de la figure 9;
- la figure 11, éclatée dans les figures partielles 11a, b, c, le dessin complet de la réalisation selon l'invention de la bascule de la figure 9.

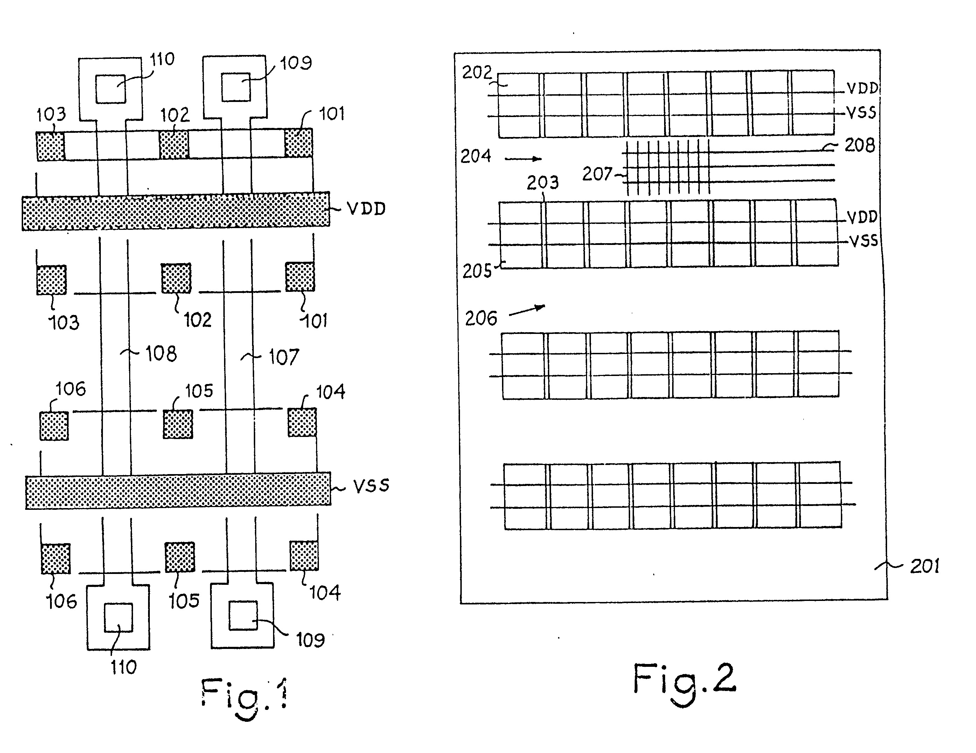

La cellule de base d'un circuit prédiffusé, qui est représentée sur la figure 1, se compose de quatre transistors MOS mis en série deux à deux. Les deux transistors MOS supérieurs sont des transistors de type P en série. Les électrodes de drain et de source de ces transistors sont accessibles en des points groupés par paires. Ainsi la source du transistor de droite est accessible par les points 101, le drain de ce même transistor, commun avec la source du transistor de gauche, est accessible par les points 102 et le drain du transistor de gauche est accessible par les points 103. En fait ces transistors sont symétriques et l'appellation de drain et de source est ici tout à fait conventionnelle, car l'électrode sera un drain ou une source selon son utilisation dans le circuit final.

De même les deux transistors du bas sont des transistors N en série dont la source du transistor de droite est accessible par les points 104, le drain de ce transistor et la source du transistor de gauche, qui sont communs, sont accessibles par les points 105, et le drain du transistor de gauche par les points 106.

Chacun de ces transistors comporte une grille, et ces grilles sont réunies entre elles, de telle manière que la grille 107 est commune aux transistors P et N de droite et la grille 108 aux transistors P et N de gauche. La grille 107 est accessible par deux points 109 situés en haut et en bas et la grille 108 par deux points 110 situés de la même manière.

Cette répartition en double des points d'accès aux différentes électrodes des transistors est faite pour faciliter l'interconnexion de ces transistors entre eux et des cellules entre elles.

L'alimentation par les tensions VDD pour les transistors P, et VSS pour les transistors N, se fait à l'aide de deux bus qui parcourent les cellules respectivement entre les points d'accès aux drains et aux sources des transistors P et les points d'accès aux drains et aux sources des transistors N.

Pour fabriquer le circuit prédiffusé de base sur lequel on déposera ensuite la grille d'interconnexion nécessaire pour réaliser les fonctions logiques désirées, on dépose sur un substrat 201 représenté en figure 2 des rangées de cellules telles que 202 et 205. Les cellules de ces rangées sont généralement séparées par un intervalle 203, où l'on fait passer une connexion permettant de relier par exemple l'espace 204, qui sépare la rangée 202 de la rangée 205, avec l'espace 206, situé entre la rangée 205 et la rangée suivante. Elles sont généralement réalisées lors de l'étape de fabrication des grilles 107 et 108, c'est-à-dire par déposition de silicium polycristallin.

Au cours de cette même étape on réalise également une série de connexions interrangées telles que 207, qui seront en attente pour réaliser des connexions verticales.

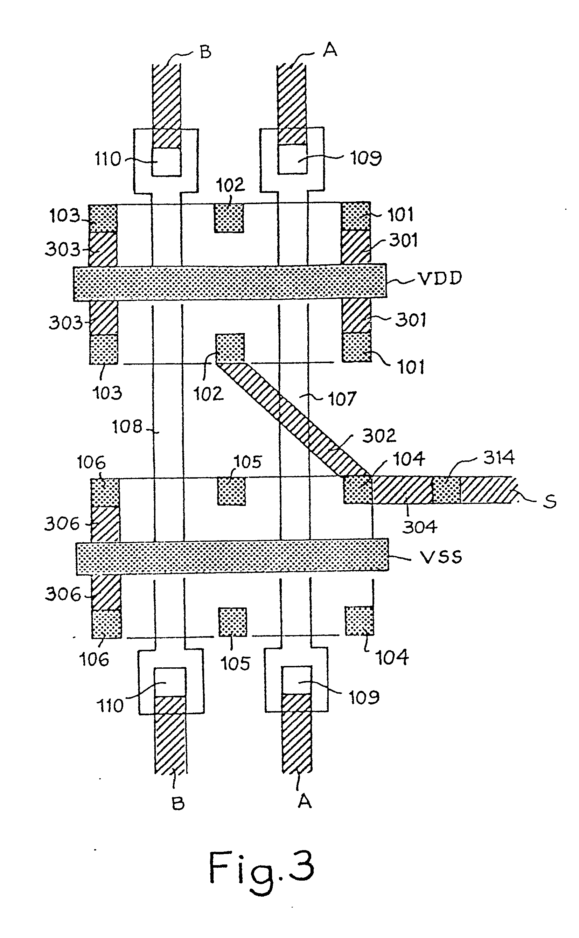

La réalisation de la fonction logique correspondant au circuit intégré à obtenir, s'effectue en prévoyant des connexions entre les différents transistors des différentes cellules. Cette interconnexion se réalise de préférence de proche en proche, tout d'abord en interconnectant les transistors d'une même cellule, puis les transistors de plusieurs cellules adjacentes, par des connexions qui ne débordent pas de la rangée de cellules. Les fonctions logiques élémentaires qui peuvent être ainsi obtenues sont en nombre limité, et on a représenté sur la figure 3, à titre d'exemple de l'une de ces fonctions, une porte du type NAND à deux entrées.

Pour cela les deux transistors P sont alimentés en parallèle à partir du bus d'alimentation VDD par les métallisations 301 et 303, reliées respectivement aux trous de connexion 101 et 103 des drains des deux transistors. L'électrode commune à ces deux transistors joue donc ici le rôle de source, et est réunie par l'intermédiaire du trou inférieur 102 à une métallisation 302, qui la relie à la source du transistor N de droite par l'intermédiaire du trou 104 supérieur. Les deux transistors N sont ici utilisés en série, et leur connexion commune n'est donc reliée à aucun circuit extérieur. Par contre le drain du transistor N de gauche est relié au bus d'alimentation VSS par une métallisation 306 qui relie les trous 106 à ce bus VSS. Le circuit d'alimentation de la cellule NAND est ainsi établi.

Les deux états logiques d'entrée sont appliqués aux grilles 107 et 108, par l'intermédiaire des trous supérieurs 109 et 110, à l'aide de deux connexions A et B. Ces deux conditions logiques se retrouvent bien entendu sur les trous inférieurs 109 et 110 des grilles, et peuvent être disponibles par exemple pour être appliquées à une autre porte par d'autres connexions A et B reliées à ces trous inférieurs.

L'état logique de sortie S de la porte est disponible sur la connexion 302 ainsi que sur les trous inférieur 102 et 104. Dans l'exemple représenté cet état logique est appliqué à une connexion 304, qui part vers la cellule qui jouxte la cellule représentée sur sa droite et qui est reliée par un trou 314 à une liaison verticale entre cellules.

Compte tenu notamment de l'obstacle représenté par le franchissement des bus d'alimentation VDD et VSS, on conçoit que les fonctions logiques susceptibles d'être réalisées par des liaisons purement internes à la rangée de cellules soit très limitées. Dans la pratique on utilise essentiellement des liaisons internes à chaque cellule, qui ne permettent alors de faire que des inverseurs et des portes NAND ou NOR. Pour aller plus loin on est obligé de déborder par des connexions dans les espaces interrangées 204, mais on n'a plus alors à proprement parler de circuits logiques de base, et l'on retombe dans l'interconnexion générale des portes du réseau. On peut bien sur réaliser n'importe quelle fonction logique à partir uniquement d'inverseurs, de NAND et de NOR, mais le câblage en est tout de suite beaucoup plus touffu, et prend donc beaucoup plus de place que si l'on avait des fonctions plus complexes comme circuits logiques de base.

Pour réaliser cette interconnexion des cellules dans les espaces interrangées tels que 204, on réalise des connexions 208 parallèles aux bus VDD et VSS et qui courent le long d'un certain nombre d'axes prédéterminés dans les espaces interrangées. Ces connexions peuvent être réunies, pour celles immédiatement adjacentes des rangées aux points de sortie des grilles tels que 109 et 110, et des sources et des drains tels que 101 à 106, directement par des connexions métalliques intégrales avec ces connexions 208. Pour les autres connexions, sauf si celles qui peuvent les séparer des rangées de cellules sont interrompues à l'endroit du passage vers la cellule adéquate, il est nécessaire de passer par les connexions interrangées 207, qui sont enterrées sous la couche isolante qui sépare la métallisation finale du reste du circuit. On ménage alors dans cette couche isolante les trous nécessaires, lors de l'étape qui précède la métallisation.

Ainsi donc, lorsque les interconnexions diverses sont déterminées, la réalisation du circuit intégré consiste, à partir d'un circuit prédiffusé recouvert de sa couche d'oxyde protectrice, à percer dans un premier temps les trous de communication avec les drains, les sources, les grilles, et les connexions interrangées et inter-espaces enterrées. Dans un deuxième temps on procède au dépot de la métallisation d'aluminium qui interconnecte ces différents trous selon le schéma désiré.

Compte tenu des diverses limitations qui ont été exposées ci-dessus, on conçoit qu'à partir d'une certaine complexité il reste de plus en plus de cellules qui ne servent à rien. C'est ainsi que pour les réseaux prédiffusés de petite taille, où l'on peut procéder au dessin de l'interconnexion manuellement, on considère qu'un taux de remplissage de 80% est satisfaisant. Aussi satisfaisant qu'il soit ce taux représente quand même 20% de perte de la surface du substrat. Dès que l'on est obligé de prendre un dispositif de routage automatique, nécessaire à partir d'une certaine taille, ce taux s'écroule pour arriver très rapidement à 50%, voire moins, résultat qui est très mauvais.

Selon l'invention, pour disposer entre les rangées de cellules d'un espace suffisant quel que soit le nombre des connexions à faire passer, on commence par supprimer les espaces interrangées tels que 204, en disposant ces rangées les unes après les autres sans garder entre elles d'intervalle particulier. Pour pouvoir alors établir les connexions nécessaires entre deux rangées de cellules, on n'alimente pas la rangée qui se trouve entre ces deux rangées qui sont alimentées. Cette rangée non alimentée reste recouverte de sa couche d'oxyde qui permet de déposer dessus des connexions en aluminium, lesquelles ne seront pas perturbées par les cellules non alimentées qui se trouvent en-dessous. Si l'espace ainsi obtenu n'est pas suffisant, on n'alimente pas une deuxième rangée de cellules, ce qui élargit l'espace et permet d'y loger toutes les connexions nécessaires. Le cas échéant on peut parfaitement augmenter encore l'espace en augmentant le nombre de rangées non alimentées.

Cette méthode suppose que l'on utilise un procédé d'interconnexion comportant deux couches d'aluminium séparées par une couche isolante, puisque l'on ne dispose plus alors des connexions polycristallines enterrées telles que 207 pour effectuer les croisements.

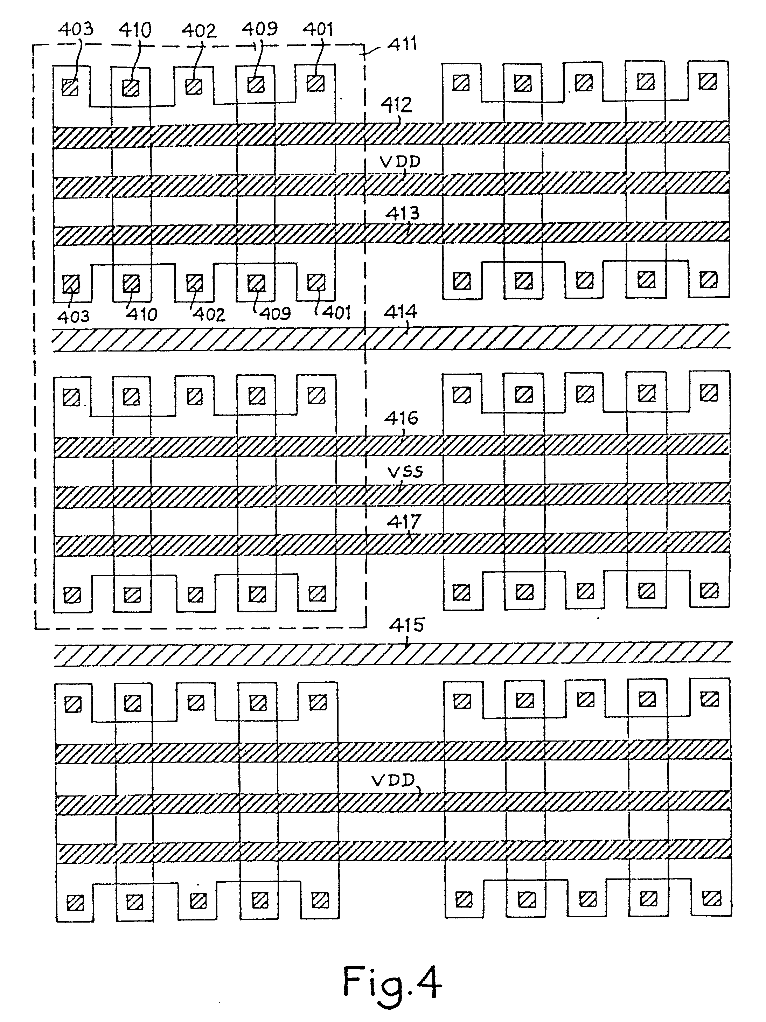

Plus précisément on a représenté sur la figure 4 une partie de la surface d'un tel circuit prédiffusé comportant six cellules appartenant à trois rangées successives.

Dans cette réalisation, pour faciliter l'interconnexion, les cellules de base utilisées correspondent en fait à des demies cellules par rapport à celles des figures 1 et 3. En effet les rangées successives sont alternativement de type P et de type N, et les grilles des transistors d'une rangée P ne sont pas réunies aux grilles des transistors de la rangée N suivante. Dans ces conditions, les deux cellules de base comprises dans le bloc pointillé 411 correspondent à la cellule complète des figures 1 et 3.

D'autre part, afin de faciliter le passage des connexions à l'intérieur des cellules, on a éloigné les points de sortie des sources et des drains, de façon à les mettre au même niveau que les points de sortie des grilles. De ce fait les points de sortie 401, 402 et 403 sont situés dans des excroissances des zones correspondant aux drains et aux sources.

La surface ainsi dégagée permet de faire courir longitudinalement entre ces points de sortie, non seulement une connexion d'alimentation VDD ou VSS, mais encore deux connexions de raccordement 412 et 413. Ces connexions sont représentées sur la figure de manière continue, mais on ne dépose bien entendu que la fraction nécessaire pour établir une connexion entre deux ou plusieurs points successifs à réunir.

Par ailleurs, dans cette réalisation on prévoit un léger intervalle interrangées, qui permet de faire courir une connexion telle que 414 entre la rangée du haut et la rangée intermédiaire, où 415 entre la rangée intermédiaire et la rangée du bas. Dans ces conditions, si l'on n'alimente pas la rangée intermédiaire, l'emplacement du bus d'alimentation VSS se trouve disponible pour effectuer des interconnexions. Compte tenu alors des deux autres lignes d'interconnexion 416 et 417, internes à cette rangée, on obtient avec les lignes 414 et 415 cinq lignes disponibles pour l'interconnexion, ce qui correspond à une valeur tout à fait courante dans les circuits prédiffusés.

Par contre, si l'on ne dispose pas d'assez de place on n'alimente pas la rangée inférieure, ce qui permet de disposer de quatre lignes d'interconnexion supplémentaires, et éventuellement d'autres si l'on continue ainsi.

Pour effectuer les interconnexions dans le sens vertical, on utilise, comme on l'a dit plus haut, un procédé à double couche métallique dans lequel, une fois que l'on a réalisé les interconnexions par l'intermédiaire des lignes décrites ci-dessus, on dépose sur le circuit une couche isolante, d'oxyde de silicium par exemple, puis une série de lignes d'interconnexion verticales, croisées avec les interconnexions horizontales et qui permettent de faire toutes les intersections.

Dans l'exemple représenté sur la figure, on a en outre ménagé entre les cellules successives d'une même rangée un intervalle de largeur sensiblement égale à celle qui existe entre les rangées successives. Il permet alors de placer une liaison verticale passant entre deux cellules, pour assurer l'interconnexion entre les liaisons horizontales situées au-dessus d'une rangée avec les liaisons horizontales situées en-dessous de cette rangée.

Pour effectuer de telles liaisons traversant une rangée, on peut également utiliser une cellule qui ne sera pas alimentée, et se servir en ce cas aussi bien des deux grilles de la cellule que des trois sources ou drains, puisque ces électrodes ont des points de connexion en haut et en bas de la cellule et que, lorsque cette cellule n'est pas alimentée, elles sont toutes isolées les unes des autres. On peut également dans ce cas faire passer des connexions métalliques de la seconde couche d'aluminium, verticalement au-dessus de cette cellule non alimentée. Cette possibilité sera cependant évitée, de même que celle consistant pour les rangées non alimentées à faire courir des connexions au-dessus des points de sortie des cellules, parce que au passage en ces points les différences d'épaisseur sont nombreuses et importantes et que la couche d'aluminium s'y fragilise facilement.

En comparant les deux cellules contenues dans le rectangle en pointillé 411, avec la cellule électriquement correspondant de la figure 1, on constate que l'on dispose dans le circuit selon l'invention d'un nombre bien plus considérable de possibilités d'interconnexions à l'intérieur d'un même couple de cellules de base correspondant à la cellule connue. Cette possibilité se répercute tout au long des deux rangées N et P correspondant à une rangée unique de la figure 2 formée des cellules de la figure 1.

Il devient alors possible d'utiliser ces interconnexions pour réaliser une bibliothèque de circuits standard, comportant un grand nombre de fonctions logiques s'étendant bien au-delà des simples portes NAND et NOR des circuits prédiffusés connus précédemment. Ces circuits standard présentent l'avantage d'être dans des dimensions multiples les unes des autres, et inscriptibles dans des couples de rangées de cellules de base.

Dans ces conditions, en utilisant de surcroit les possibilités d'interconnexion entre les rangées qui ont été décrites plus haut, on peut utiliser dans une structure de circuit prédiffusé les méthodes de placement et de routage qui ont fait la preuve de leur efficacité pour les circuits à circuits standard. C'est-à-dire que l'on appelle les circuits standard correspondant aux circuits logiques désirés de la bibliothèque pour les placer sur les rangées, puis que l'on utilise le programme de routage pour définir les interconnexions entre ces rangées. On sait que ces programmes de routage peuvent être efficaces à 100%, et l'on a alors un procédé de fabrication de circuits intégrés qui présente simultanément les avantages de standardisation des circuits prédiffusés, avec les avantages d'efficacité dans la conception et dans l'utilisation de la surface de substrat des circuits standard.

Comme dans les circuits standard la bibliothèque peut être très importante. A titre d'exemple on va décrire la réalisation d'un circuit relativement simple du type NAND à deux entrées, et un circuit beaucoup plus complexe du type bascule D statique.

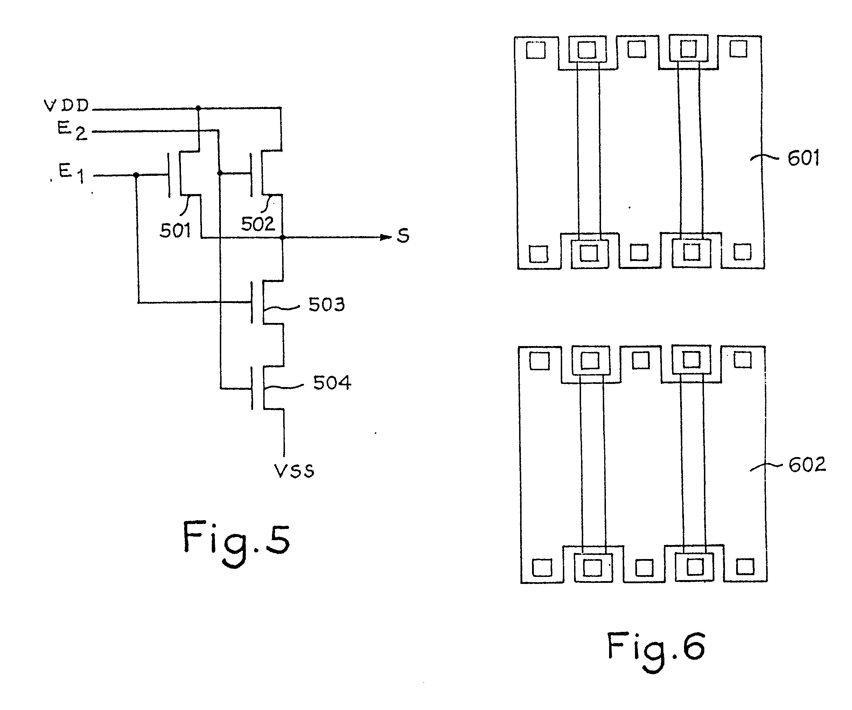

Le schéma électrique d'une porte NAND à deux entrées est représenté sur la figure 5. Il comporte deux transistors MOS 501 et 502 du type P alimentés en parallèle par une source d'alimentation VDD. Ces deux transistors en parallèle sont connectés en série avec deux transistors MOS 503 et 504 du type N, dont le deuxième est relié à la source d'alimentation VSS. L'une des entrées E1 est reliée en parallèle aux grilles des transistors 501 et 503, et l'autre entrée E2 est reliée en parallèle aux grilles des transistors 502 et 504. La sortie S de la porte est prise sur la connexion commune aux drains des transistors 501 et 502 et à la source du transistor 503.

Ce schéma très simple est réalisé avec deux cellules de base du type de celle de la figure 4, et va être décrit plus en détail pour faciliter la compréhension de la représentation des schémas de réalisation.

Pour réaliser ce circuit on utilise deux cellules 601 et 602 respectivement P et N appartenant à deux rangées successives et situées l'une au-dessus de l'autre. Ces cellules sont représentées nues sur la figure 6. Conformément aux conventions antérieures les trous dans la couche d'oxyde finale qui protège le circuit, qui permettent d'accéder aux drains, aux sources et aux grilles des transistors, sont représentés par des carrés.

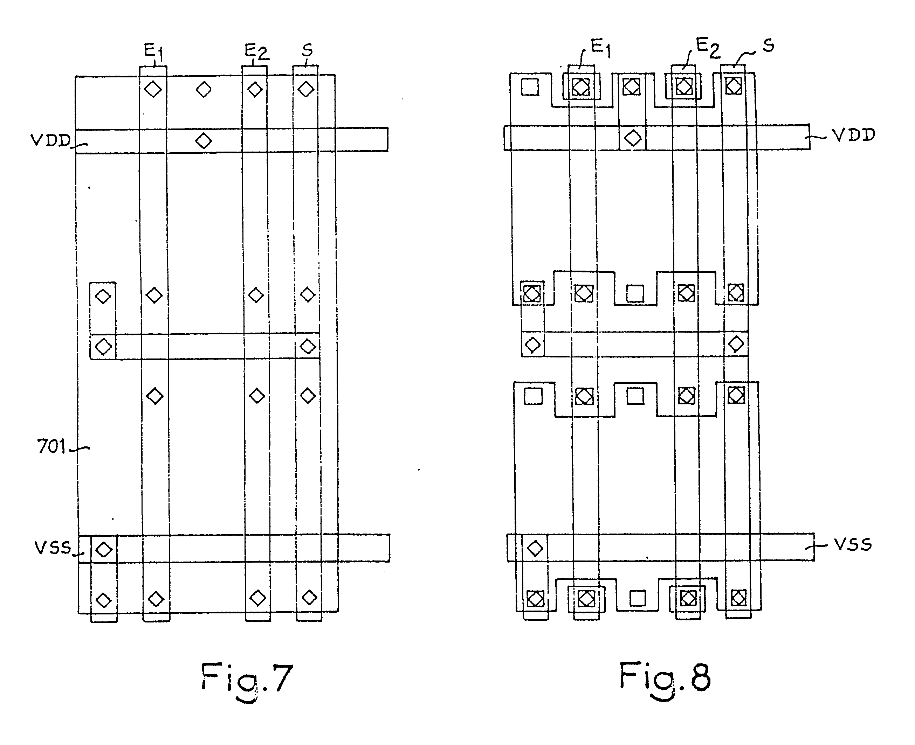

Le réseau de connexions d'aluminium qui permet à partir de ces cellules de réaliser la porte NAND à deux entrées désirée est représenté sur la figure 7. Sur cette figure, on distingue dans le cadre 701 qui délimite la surface des deux cellules, des connexions horizontales, telles que les connexions VDD et VSS qui correspondent aux deux bus d'alimentation, qui sont obtenues lors de la première déposition d'aluminium sur la couche d'oxyde protégant le circuit prédiffusé. Les connexions verticales, telles que E1 et E2 pour les deux entrées et S pour la sortie, sont obtenues lors de la déposition de la deuxième couche d'aluminium sur la couche intermédiaire d'oxyde isolant déposée après la première déposition d'aluminium. Pour permettre les connexions entre les connexions horizontales et verticales correspondant à ces deux couches, ainsi qu'entre les connexions verticales de la deuxième couche et certain des points d'accès aux sources, aux drains et aux grilles, on réalise dans la couche d'oxyde intermédiaire des orifices placés aux points de croisement ou sur les points d'accès aux transistors. Ces orifices sont représentés sur la figure par des losanges pour les distinguer de ceux d'accès aux électrodes des transistors. Cette représentation dans les deux cas n'est que symbolique.

La figure 7 est plus lisible, mais moins compréhensible que la combinaison des figures 6 et 7, qui donne la représentation complète de la porte décrite. Pour cette raison on a représenté sur la figure 8 la superposition de ces deux figures 6 et 7. Cette figure 8 donne donc tous les détails de réalisation d'une porte NAND à deux entrées par le procédé selon l'invention.

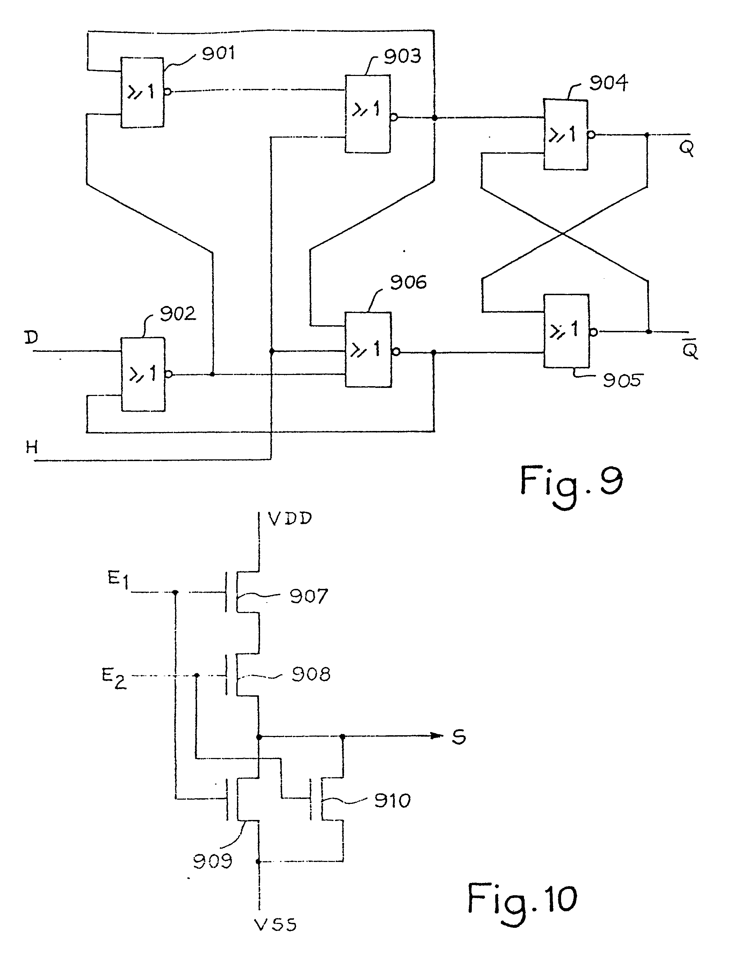

La figure 9 représente le schéma logique d'une bascule de type D statique, réalisée à partir de cinq portes NOR à deux entrées 901 à 905 et d'une porte NOR à trois entrées 906. Cette bascule fonctionne à partir de deux signaux d'entrée, l'un D de données et l'autre H d'horloge, et délivre deux signaux de sortie complémentaires Q et $\bar{Q}$.

Le schéma électrique de l'une des portes NOR à deux entrées est représenté sur la figure 10. Il est tout à fait complémentaire du schéma électrique de la figure 5 représentant une porte NAND. On y trouve deux transistors P 907 et 908, alimentés en série à partir de la source d'alimentation VDD et alimentant eux-mêmes deux transistors N 909 et 910 en parallèle, qui sont réunis à la source d'alimentation VSS. L'un des signaux d'entrée E1 est appliqué en parallèle sur les grilles des transistors 907 et 909, et l'autre signal d'entrée E2 est appliqué en parallèle sur les grilles des transistors 908 et 910. Une porte NOR à trois entrées, telle que la porte 906, comportera trois transistors P en série et trois transistors en parallèle, chaque grille d'un transistor P étant réunie à une grille d'un transistor N et recevant l'un des trois signaux d'entrée.

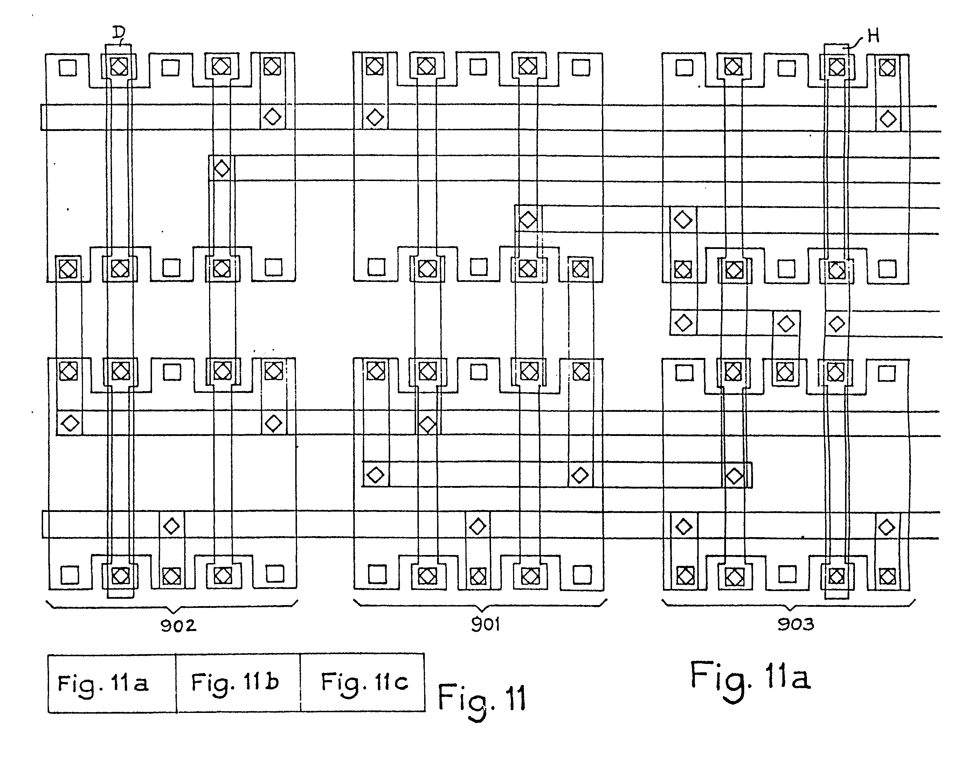

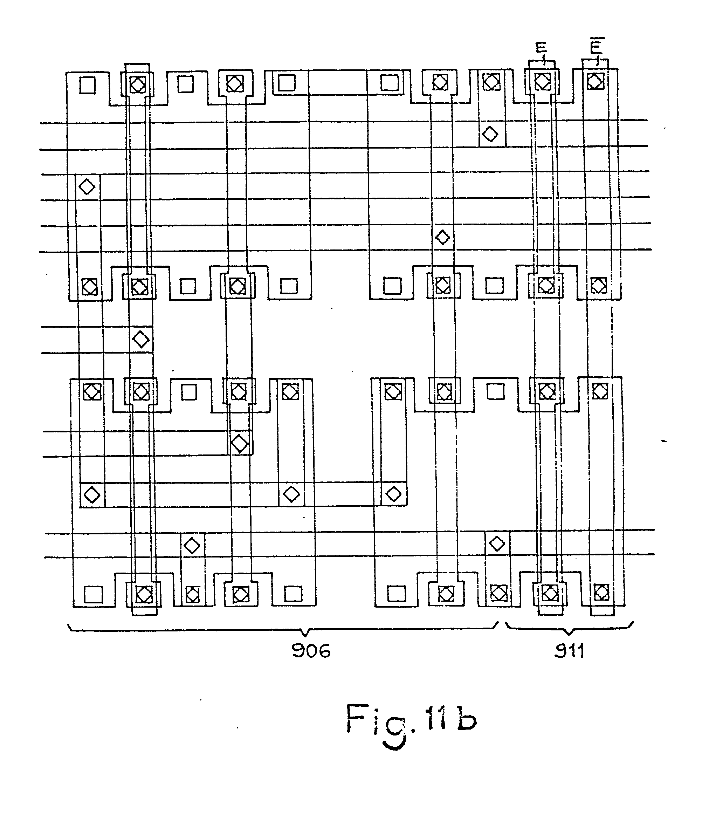

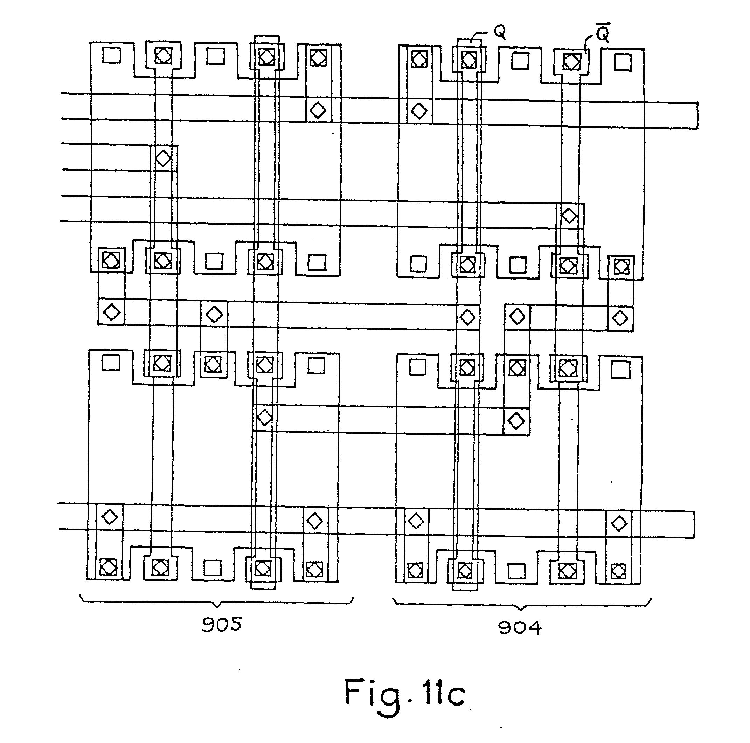

En utilisant les conventions de dessin qui ont été expliquées à propos de la porte NAND à deux entrées, on a représenté sur la figure 11, éclatée sur les trois figures 11A, 11B et 11C la représentation complète comportant les différentes couches superposées du circuit de bibliothèque correspondant à cette bascule D statique.

Ce schéma utilise sept paires de cellules de base P et N successives, appartenant à deux rangées P et N successives. La première paire réalise la porte 902 et reçoit le signal D. La deuxième paire réalise la porte 901. La troisième paire réalise la porte 903 et reçoit le signal H. La porte 906 qui comprend trois entrées est réalisée par la quatrième paire et les deux premiers transistors P et N de la cinquième paire. La sixième paire réalise la porte 905. La septième paire réalise la porte 904 et délivre les signaux, Q et $\bar{Q}$.

Les deux transistors de la cinquième paire, qui étaient libres, ont été utilisés pour réaliser un inverseur recevant un signal E et délivrant le signal $\bar{E}$. En effet il est toujours utile de disposer d'inverseurs dans un circuit logique, et il est préférable de prévoir ceux-ci directement dans les circuits de la bibliothèque, de façon à bien séparer les programmes qui servent à réaliser le câblage des circuits de ceux qui servent à réaliser le câblage intercircuit.

On constate bien que l'ensemble du câblage de la bascule est contenu à l'intérieur du rectangle défini par les sept paires de cellules de base, ce qui laisse entièrement libre l'espace extérieur pour procéder au câblage intercircuits. De plus on dispose pour ce même câblage intercircuits de six liaisons verticales entre les cellules de base de la bascule.

On constate donc que le procédé selon l'invention réalise en fait une synthèse entre la technique des circuits prédiffusés et celle des circuits standard. En effet on peut sur un substrat prédiffusé répartir à volonté des circuits standard appelées d'une bibliothèque puis procéder au câblage entre ceux-ci comme dans la technique des circuits standard.

## Revendications

1. Circuit intégré prédiffusé du type comportant sur un substrat des rangées (202) de cellules de base dont certains, inactives, permettent le passage de connexions, caractérisé en ce qu'il comprend une succession continue de rangées alternativement de type N et P dans lesquelles chaque cellule de base comporte deux transistors MOS, qui sont mis en série par une paire d'électrodes drain source communes (402) et qui ont leurs grilles (409, 410) distinctes, les paires de points de connexion (401, 403) des électrodes drain source des transistors étant situés dans l'alignement des paires de points de connexion des grilles (409, 410), ce qui permet le passage d'au moins trois lignes de connexion longitudinales (412, VDD, 413) entre deux alignements de paires de points de connexion (401, 402, 403, 409, 410) desservant les mêmes cellules de base.

2. Circuit intégré selon la revendication 1, caractérisé en ce que les écartements entre les rangées et entre les cellules de base permettent respectivement le passage d'une ligne de connexions longitudinales et d'une ligne de connexions transversales.

3. Procédé d'interconnexion d'un circuit intégré prédiffusé selon l'une des revendications précédentes, dans lequel on utilise la surface d'au moins une rangée de cellules de base, non alimentées, pour faire passer des connexions reliant les cellules entre elles et à volonté la surface d'au moins une cellule de base, non alimentée, pour faire passer des connexions transversales, caractérisé en ce qu' on utilise une bibliothèque de circuits standards composés de cellules de base de deux rangées N et P successives contenues dans un rectangle de dimensions déterminées propres au circuit standard, les connexions entre cellules de base d'un circuit standard, qui déterminent la fonction logique dudit circuit standard, étant contenues dans le rectangle délimitant ce circuit standard.

4. Procédé selon la revendication 3, caractérisé en ce que l'on utilise une méthode de placement et de routage comme pour des circuits intégrés dont les cellules standard ne sont pas prédiffusées.

**Patentansprüche**

1. Vordiffundierter integrierter Schaltkreis mit einem Substrat, auf dem Reihen (202) von Basiszellen angeordnet sind, von denen bestimmte, nämlich inaktive, den Durchlaß von Verbindungen erlauben, dadurch gekennzeichnet, daß er eine fortlaufende Folge von abwechselnd N und P dotierten Reihen aufweist, in denen jede Basiszelle zwei MOS-Transistoren besitzt, die über ein Paar von gemeinsamen Drain-Source-Elektroden (402) in Reihe geschaltet sind und deren Gate-Elektroden (409, 410) nicht gemeinsam sind, wobei die Verbindungspunktpaare (401, 403) der Drain-Source-Elektroden der Transistoren in Flucht mit den Verbindungspunktpaaren der Gate-Elektroden (409, 410) angeordnet sind, so daß es möglich ist, mindestens drei Verbindungsleitungen in Längsrichtung (412, VDD, 413) zwischen zwei fluchtenden Anordnungen von Verbindungspunktpaaren (401, 402, 403, 409, 410) hindurch zu verlegen, die dieselben Basiszellen bedienen.

2. Integrierter Schaltkreis nach Anspruch 1, dadurch gekennzeichnet, daß die Abstände zwischen den Reihen und den Basiszellen die Hindurchführung einer Verbindungsleitung in Längsrichtung und einer Verbindungsleitung in Querrichtung erlauben.

3. Verfahren zum Herstellen der internen Verbindungen eines vordiffundierten integrierten Schaltkreises nach einem der vorhergehenden Ansprüche, in dem die Oberfläche mindestens einer Reihe von nicht mit Strom versorgten Basiszellen zur Durchführung der Verbindungen verwendet wird, die die Zellen untereinander verbinden, und nach Wunsch die Oberfläche mindestens einer nicht mit Strom versorgten Basiszelle, um die Querverbindungen hindurchzuführen, dadurch gekennzeichnet, daß man eine Bibliothek von zusammengesetzen Normschaltkreisen von Basiszellen mit zwei aufeinanderfolgenden N und P dotierten Reihen verwendet, die in einem Rechteck vorgegebener und für den Normschaltkreis typischer Abmessungen enthalten sind, wobei die Verbindungen zwischen Basiszellen eines Normschaltkreises, die die logische Funktion dieses Normschaltkreises bestimmen, im Rechteck enthalten sind, das diesen Normschaltkreis umgrenzt.

4. Verfahren nach Anspruch 3, dadurch gekennzeichnet, daß man dieselbe Plazierungs- und Verlaufsmethode wie für integrierte Schaltkreise verwendet, deren Normzellen nicht vordiffundiert sind.

**Claims**

1. A prediffused integrated circuit comprising a substrate and rows (202) of basic cells thereon, certain inactive cells of which allow the passage of connection lines, characterized in that it comprises a continuous succession of alternately N and P doped rows in which each basic cell comprises two MOS transistors, these transistors being series connected via a pair of common drain-source electrodes (402) and having distinct grid electrodes (409, 410), the pairs of connection points (401, 403) of the drain-source electrodes of the transistors being situated in alignment with the pairs of connection points of the gates (409, 410), thus allowing the passage of at least three longitudinal connection lines (412, VDD, 413) between two alignments of pairs of connection points (401, 402, 403, 409, 410) associated to the same basic cell.

2. An integrated circuit according to claim 1, characterized in that the spaces between the rows and between the basic cells permit the passage of a longitudinal connection line and of a transverse connection line.

3. An interconnection method for a prediffused integrated circuit according to one of the preceding claims, in which the surface of at least one row of basic cells which are not power supplied is utilized for passing inter-cell connections therethrough, and, if desired, the surface of at least one basic cell which is not power supplied is utilized for passing transverse connections therethrough, characterized in that a library of standard circuits composed of basic cells of two successive N and P doped rows is used which are contained in a rectangle of predetermined dimensions typical for the standard circuit, the inter-cell connections of a standard circuit which determine the logic function of said standard circuit being contained within the rectangle which delimits said standard circuit.

4. A method according to claim 3, characterized in that a placing and routing method is employed similar to that for integrated circuits in which the standard cells are not prediffused.

Fig.1

Fig.2

0 090 704

Fig.3

Fig.4

Fig.5

Fig.6

Fig.7

Fig.8

Fig. 9

Fig. 10

Fig. 11a

Fig. 11

| Fig. 11a | Fig. 11b | Fig. 11c |

13

Fig. 11 b

Fig.11c